# EUROPEAN PATENT SPECIFICATION

(11) **EP 4 376 089 B1**
(45) Date of publication and mention of the grant of the patent: **14.10.2026**
(21) Application number: 23209667.7
(22) Date of filing: 14.11.2023
(51) Int. Cl.: H10D 62/10, H10D 62/832

(54) **SILICON CARBIDE INTEGRATED DEVICE AND METHOD FOR MANUFACTURING AN INTEGRATED DEVICE**
INTEGRIERTE SILIZIUMKARBID-VORRICHTUNG UND VERFAHREN ZUR HERSTELLUNG EINER INTEGRIERTEN VORRICHTUNG
DISPOSITIF INTÉGRÉ EN CARBURE DE SILICIUM ET PROCÉDÉ DE FABRICATION D'UN DISPOSITIF INTÉGRÉ

(30) Priority: 22.11.2022 IT 202200023976
(43) Date of publication of application: 29.05.2024
(73) Proprietor: STMicroelectronics S.r.l., 20864 Agrate Brianza (MB) (IT)
(72) Inventor: FRAGAPANE, Leonardo, 95121 CATANIA (IT)
(74) Representative: Studio Torta S.p.A.

(56) References cited:
- JP-A- 2011 187 767
- US-A1- 2015 372 075
- US-A1- 2022 238 643
- US-A1- 2022 293 746

## Description

### TECHNICAL FIELD

The present invention relates to a silicon carbide integrated device and to a method for manufacturing an integrated device.

### BACKGROUND

As is known, Silicon Carbide (SiC) has advantageous electrical properties, such as high band gap, high critical electric field and high thermal conductivity, which make its use particularly promising for high-power, high-voltage, fast-switching and high-operating temperature applications.

It is also known that, in the edge termination structure, the maximum theoretical value of the breakdown voltages of the integrated power devices is limited by the so-called potential lines crowding effect, which occurs both in the case of devices formed in a silicon substrate, and in devices formed in a silicon carbide substrate. The development of an effective edge termination structure, which allows reaching a breakdown voltage close to the theoretical values, is a fundamental requirement in the design of integrated power devices.

Several solutions of edge termination structures have been proposed, intended to mitigate edge effects. In general, the proposed techniques aim at modifying the distribution of the electric field at the periphery of the main junction of the integrated power device, so as to reduce the peak value of the surface electric field. Some of these solutions have also been implemented in the field of integrated power devices formed in silicon carbide substrates, suitably adapted to take into account the main electrical characteristics of silicon carbide itself; in general, however, the direct transition of edge termination techniques from silicon to silicon carbide is quite problematic, due to the different properties of the two materials and to the resulting different processing techniques and the different electrical behaviour.

Among these properties, for example, the reduced diffusivity of the dopants within silicon carbide, compared to silicon, is known.

According to a known solution, for example, a ring region is formed in a silicon or silicon carbide substrate of an integrated power device around a main junction region of the integrated power device. The solution is simple and requires a single mask and a single dopant implant to form the ring region, but it does not allow the electric field distribution to be accurately controlled (generally, electric field peaks are found at the boundary of the ring region). It has also been proposed to form a plurality of separate and concentric ring regions, the innermost of which is in contact with the main junction region. The ring regions have variable width, as well as the separation distance between adjacent ring regions is variable. During the design step, the width and the separation distance may be suitably sized to obtain a desired pattern of the electric field at the edge termination structure. The solution allows a better control of the electric field, while maintaining a good easiness in manufacturing. A single mask and a single dopant implant may in fact be sufficient.

According to a further known solution, described in US 2015/0372075 A1, an edge termination structure comprises a plurality of ring portions, each made by a respective doped region which is in turn annular-shaped. Each ring portion has a respective width (or smaller dimension) in the horizontal plane and a respective junction depth in the vertical direction. The ring portions are contiguous and arranged side by side to each other, so as to form a single ring region, that is continuous and seamless. The inner ring portions have greater depth and the outer ring portions have gradually decreasing depth. Furthermore, the ring portions have respective amounts of charge decreasing from the inside out.

The edge termination structure may be formed by successive implants having decreasing depth (or, conversely, having increasing depth) in a structural layer containing silicon carbide (for example a substrate or an epitaxial layer). For example, the deepest part of the innermost ring portion may be formed with a first implant. With a successive implant, less deep, but still sufficient to reach the already-implanted region, one part of the innermost ring portion and one part of the immediately outer ring portion are formed. The part of the inner ring portion formed with the most recent implant is stacked on and in contact with the previously formed part. Successive implants are performed up to reaching the surface of the structural layer. Each implant is shallower and laterally more extended than the previous ones and allows new parts of the already formed inner ring portions and one part of a new outer ring portion to be formed. The edge termination structure thus obtained has a stepped profile which approximates an ideal profile degrading in a regular manner towards the periphery, for example a parabolic profile. The electric field control is generally improved, however the steps at the transitions between adjacent ring portions cause electric field peaks that have such amplitude as to create stress in the surface oxides. Although the values of the breakdown voltages may initially be satisfactory, the stress due to the electric field peaks may induce premature aging and compromise the reliability of the devices.

On the other hand, the limits of the lithographic techniques used to define the masks and the number of implants do not allow the widths of the steps to be reduced beyond a certain limit, which may not be sufficient.

In general, none of the known edge termination structures are therefore optimized for use in integrated power devices formed in silicon carbide substrates.

JP 2011 187767 A discloses an integrated device, comprising: a semiconductor structural layer, including silicon carbide and having a first conductivity type, a power device integrated in the structural layer; and an edge termination structure, extending in a ring around the power device and having a second conductivity type. The edge termination structure comprises a plurality of ring structures each arranged around the power device and in contiguous pairs. At least a first one of the ring structures comprises a transition region contiguous to a second one of the ring structures. The transition region includes connection regions, having the second conductivity type, connected to the second one of the ring structures and alternated with charge control regions having the first conductivity type.

Other examples of known devices and methods are disclosed in US 2022/238643 A1 and US 2015/372075 A1.

### SUMMARY

The aim of the present invention **is** to provide an integrated device and a method for manufacturing an integrated device which allow the limitations described to be overcome or at least mitigated.

According to the present invention an integrated device and a method for manufacturing an integrated device are provided as defined in claims 1 and 13, respectively.

### BRIEF DESCRIPTION OF THE DRAWINGS

For a better understanding of the invention, some embodiments thereof will now be described, purely by way of non-limiting example and with reference to the attached drawings, wherein:
- Figure 1 is a top-plan view, with parts removed for clarity, of an integrated device in accordance with an embodiment of the present invention;
- Figure 2 shows an enlarged detail of the integrated device of Figure 1;
- Figure 3 is a cross-section through the integrated device of Figures 1 and 2, taken along line III-III of Figure 2;
- Figure 4 is a cross-section through the integrated device of Figures 1 and 2, taken along line IV-IV of Figure 2;
- Figure 5 is a cross-section through the integrated device of Figures 1 and 2, taken along line V-V of Figure 2;
- Figure 6 is a cross-section through the integrated device of Figures 1 and 2, taken along line VI-VI of Figure 2;
- Figure 7 is a cross-section through the integrated device of Figures 1 and 2, taken along line VII-VII of Figure 2;
- Figure 8 is a first cross-section through an integrated device in accordance with a different embodiment of the present invention;
- Figure 9 is a second cross-section through the integrated device of Figure 8;
- Figure 10 is a top-plan view, with parts removed for clarity, of a detail of an integrated device in accordance with a further embodiment of the present invention;
- Figure 11 is a cross-section through the integrated device of Figure 10, taken along line XI-XI of Figure 10;
- Figure 12 is a cross-section through the integrated device of Figure 10, taken along line XII-XII of Figure 10;
- Figure 13a and 13b are graphs showing quantities relating to the integrated device of Figure 10;
- Figure 14 is a top-plan view of a semiconductor body in an initial step of a method for manufacturing an integrated device in accordance with an embodiment of the present invention;
- Figure 15 is a cross-section through the semiconductor body of Figure 14, taken along line XV-XV of Figure 14;
- Figure 16 is a cross-section through the semiconductor body of Figure 14, taken along line XVI-XVI of Figure 14;
- Figure 17 is a top-plan view of the semiconductor body of Figure 14 in a successive step of the present method;
- Figure 18 is a cross-section through the semiconductor body of Figure 17, taken along line XVIII-XVIII of Figure 17;
- Figure 19 is a cross-section through the semiconductor body of Figure 17, taken along line XIX-XIX of Figure 17;

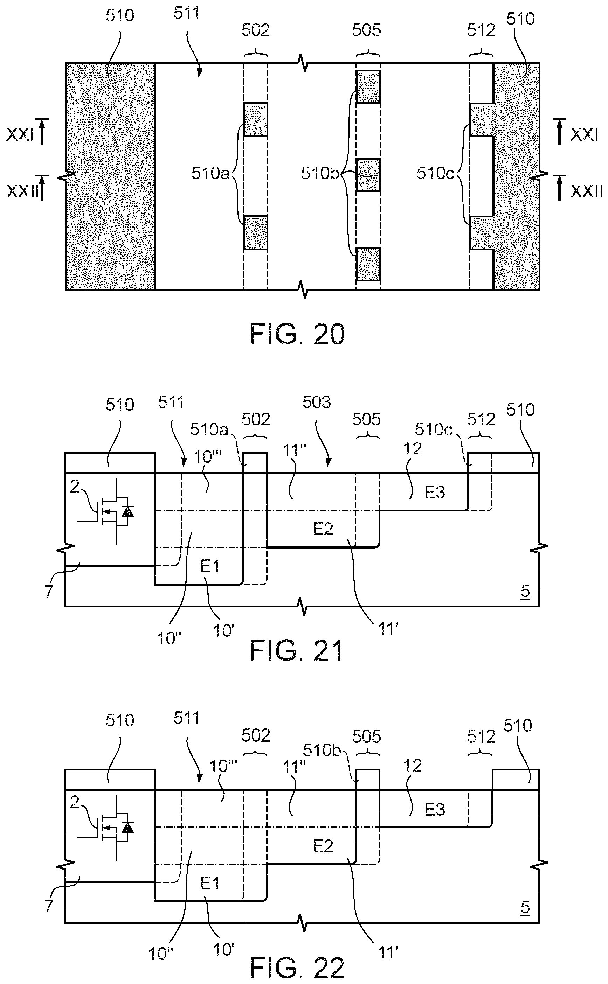

- Figure 20 is a top-plan view of the semiconductor body of Figure 17 in a further successive step of the present method;
- Figure 21 is a cross-section through the semiconductor body of Figure 20, taken along line XXI-XXI of Figure 20; and
- Figure 22 is a cross-section through the semiconductor body of Figure 20, taken along line XXII-XXII of Figure 20.

### DESCRIPTION OF THE EMBODIMENTS

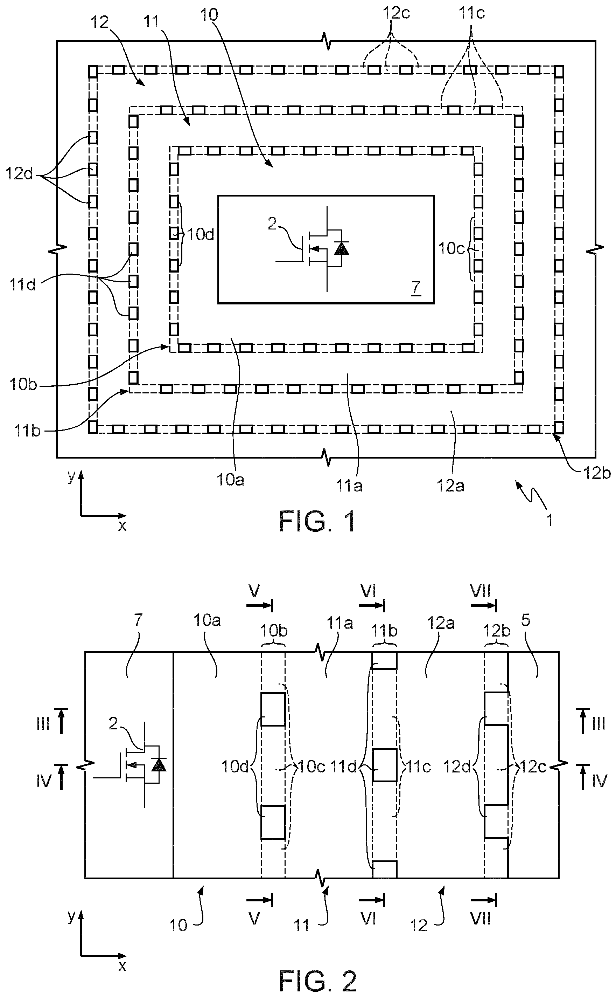

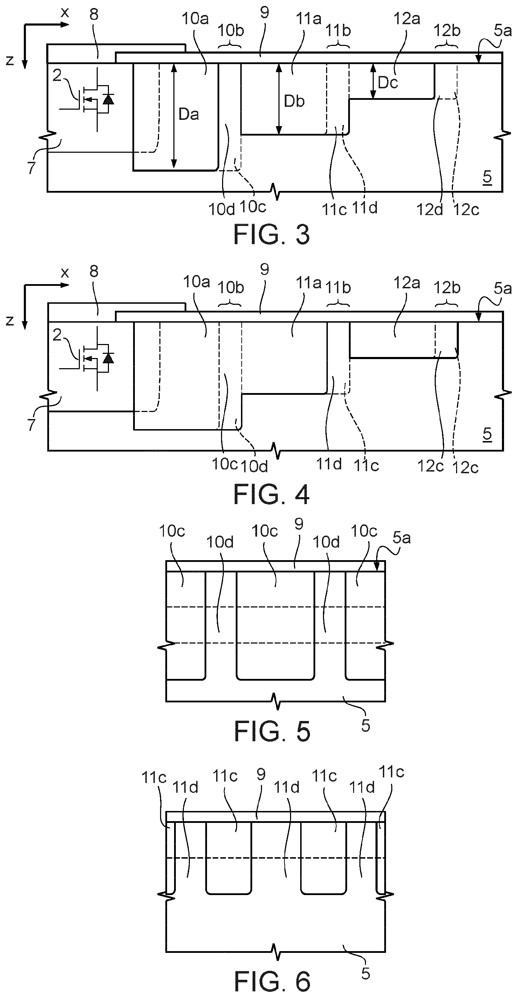

With reference to Figures 1-7, a semiconductor integrated device, indicated as a whole with the number 1, comprises a power device 2 and an edge termination structure 3, which surrounds the power device 2. More precisely, the integrated device 1 comprises a semiconductor structural layer 5 (better visible in Figures 3 and 4), for example a substrate or an epitaxial layer, containing silicon carbide; the power device 2 and the edge termination structure 3 are formed in the structural layer 5.

The structural layer 5 has a front face 5a (Figures 3 and 4) arranged in an xy plane and has a first doping type and a first conductivity type, for example of N-type.

In a non-limiting example, the power device 2 is a SiC MOSFET and has functional regions 7 (one of which is visible in Figures 3 and 4) in a peripheral portion, in contact with the edge termination structure 3. The functional regions 7 have a second doping type and a second conductivity type, here P-type, and form PN junctions with the structural layer 5. The functional regions 7, for example body wells, are generically peripheral structures of the power device 2 and may have a role in generating current or in insulating parts of the same power device 2.

A metal structure 8, so-called "field plate" structure, extends on the structural layer 5 (Figures 3 and 4) and is placed directly in contact with the functional region 7. The metal structure 8 is also separated from the edge termination structure 3 by a field plate oxide 9.

The edge termination structure 3 has an annular shape (Figure 1) and surrounds the functional region 7. Here and in the following, it is understood that an annular structure or region generically extends along a closed, not necessarily circular, path. For example, the edge termination structure 3 may be rectangular, as in the embodiment of Figures 1-7, generally polygonal or rectangular elliptical.

In detail, the edge termination structure 3 comprises a plurality of concentric and contiguous ring structures, each having a respective continuous annular region. Furthermore, at least one of the ring structures has a transition region which is also of annular shape, extending around the respective continuous annular region and in contact with the continuous annular region of the immediately outer ring structure.

In the embodiment of Figures 1-7, the edge termination structure 3 comprises three ring structures, more precisely an inner ring structure 10, an intermediate ring structure 11 and an outer ring structure 12.

The ring structures 10-12 extend from the front face 5a towards the inside of the structural layer 5, each up to a respective depth. The depths of the ring structures 10-12 degrade towards the outside. More precisely, the inner ring structure 10 extends up to a maximum depth Da and the outer ring structure 12 extends up to a minimum depth Dc, while the intermediate ring structure 11 extends up to an intermediate depth Db, comprised between the maximum depth Da and the minimum depth Dc.

Each ring structure 10-12 comprises a respective inner continuous annular region 10a-12a and a respective transition region 10b-12b around the respective continuous annular region 10a-12a. The transition regions 10b-12b in turn comprise respective connection regions 10c-12c alternated with charge control regions 10d-12d along the perimeter of the respective continuous annular regions 10a-12a. The continuous annular regions 10a-12a and the connection regions 10c-12c have the second doping type and the second conductivity type (P-type in the described embodiment). The charge control regions 10d-12d have the same doping type and level and the same conductivity type as the structural layer 5 (first doping type and first conductivity type). In practice, as will be seen in detail hereinafter, the continuous annular regions 10a-12a and the connection regions 10c-12c are obtained by dopant implants in the structural layer 5, while the charge control regions 10d-12d are portions of the structural layer 5 preserved by the implants and therefore not modified during the process.

In detail, towards the inside, the continuous annular region 10a of the inner ring structure 10 is contiguous to the functional region 7. The transition region 10b is arranged around the continuous annular region 10a and is contiguous to the continuous annular region 11a of the intermediate ring structure 11. The transition region 10b comprises a plurality of connection regions 10c alternated with a plurality of charge control regions 10d. The connection regions 10c join the continuous annular region 10a of the inner ring structure 10 to the continuous annular region 11a of the intermediate ring structure 11. In the embodiment of Figures 1-7, the charge control regions 10d of the inner ring structure 10 extend continuous and straight from the front face 5a of the structural layer 5 up to the maximum depth Da of the same inner ring structure 10 (more precisely, of its continuous annular region 10a and its connection regions 10c).

The continuous annular region 11a of the intermediate ring structure 11 is arranged around the transition region 10b of the inner ring structure 10. The transition region 11b is arranged around the continuous annular region 11a and is contiguous to the continuous annular region 12a of the outer ring structure 12. The transition region 11b comprises a plurality of connection regions 11c and a plurality of charge control regions 11d, which join the continuous annular region 11a of the intermediate ring structure 11 to the continuous annular region 12a of the outer ring structure 12. In the embodiment of Figures 1-7, the charge control regions 11d of the intermediate ring structure 11 extend continuous and straight from the front face 5a of the structural layer 5 up to the intermediate depth Db of the same intermediate ring structure 11 (more precisely, of its continuous annular region 11a and its connection regions 11c).

The continuous annular region 12a of the outer ring structure 12 is arranged around the transition region 11b of the intermediate ring structure 11. The transition region 12b is optional. If present, as in the embodiment of Figures 1-7, the transition region 12b is arranged around the continuous annular region 12a and is contiguous to the structural layer 5. The transition region 12b comprises a plurality of connection regions 12c and a plurality of charge control regions 12d, which join the continuous annular region 12a of the outer ring structure 12 to the continuous annular region 12a of the outer ring structure 12. In the embodiment of Figures 1-7, the charge control regions 12d of the outer ring structure 12 extend continuous and straight from the front face 5a of the structural layer 5 up to the minimum depth Dc of the same outer ring structure 12 (more precisely, of its continuous annular region 12a and its connection regions 12c).

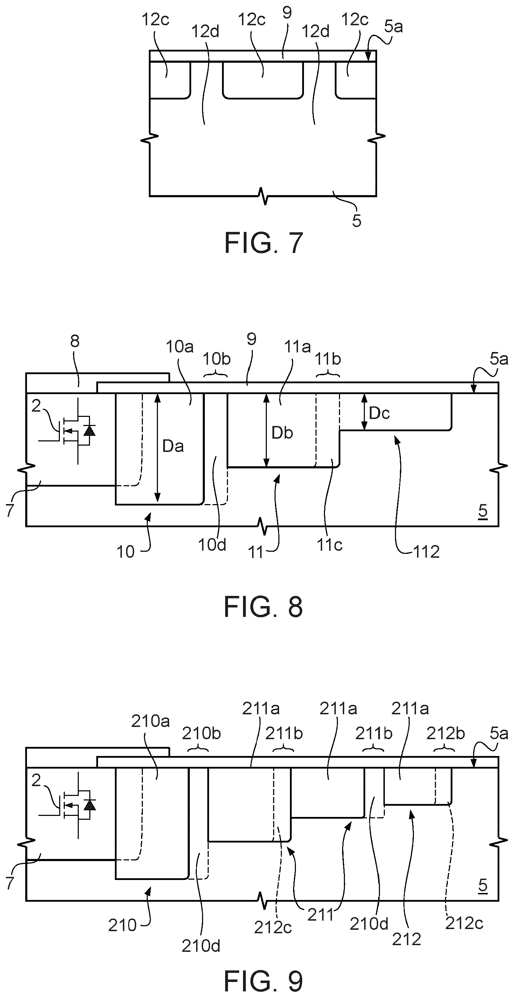

Transition regions are not necessarily present in all the ring structures and may or may not be included in accordance with design preferences. According to the embodiment of Figure 8, for example, in an edge termination structure 100 the outer ring structure, here indicated by 112, has no transition region towards the structural layer 5.

The number, the shape and the dimensions of the ring structures forming the edge termination structure may be different from those illustrated in Figures 1-7 and may be chosen according to the design preferences. For example, the edge termination structure may comprise only two ring structures, an inner one and an outer one, with the inner ring structure provided with a transition region. Optionally, the outer ring structure may also be provided with a transition region. Alternatively, the edge termination structure may comprise an inner ring structure, an outer ring structure and a plurality of concentric intermediate ring structures. Transition regions are also present in at least one of the inner and intermediate ring structures and, optionally, also in the outer ring structure. Furthermore, in case two or more intermediate ring structures are present, each of them extends up to a respective intermediate depth between the maximum depth Da and the minimum depth Dc and the outer ring structures have a shallower depth than the inner ring structures.

In the embodiment of Figure 9 an integrated device 200 is provided with an edge termination structure 203 which comprises an inner ring structure 210, a plurality of intermediate ring structures 211 (two in the non-limiting example of Figure 9) and an outer ring structure 212, all concentric and contiguous to each other in pairs. The inner ring structure 210, the intermediate ring structures 211 and the outer ring structure 212 are provided with continuous annular regions, respectively indicated by 210a, 211a, 212a, and with transition regions, substantially as already described and respectively indicated by 210b, 211b, 212b. In particular, the transition regions 210b, 211b, 212b comprise respective connection regions 210c, 211c, 212c alternated with respective charge control regions 210d, 211d, 212d.

In the embodiments described, the charge control regions are columnar in shape and extend from the front face 5a towards the inside of the structural layer 5, each up to the depth of the respective ring structure. However, this shape should not be considered limiting.

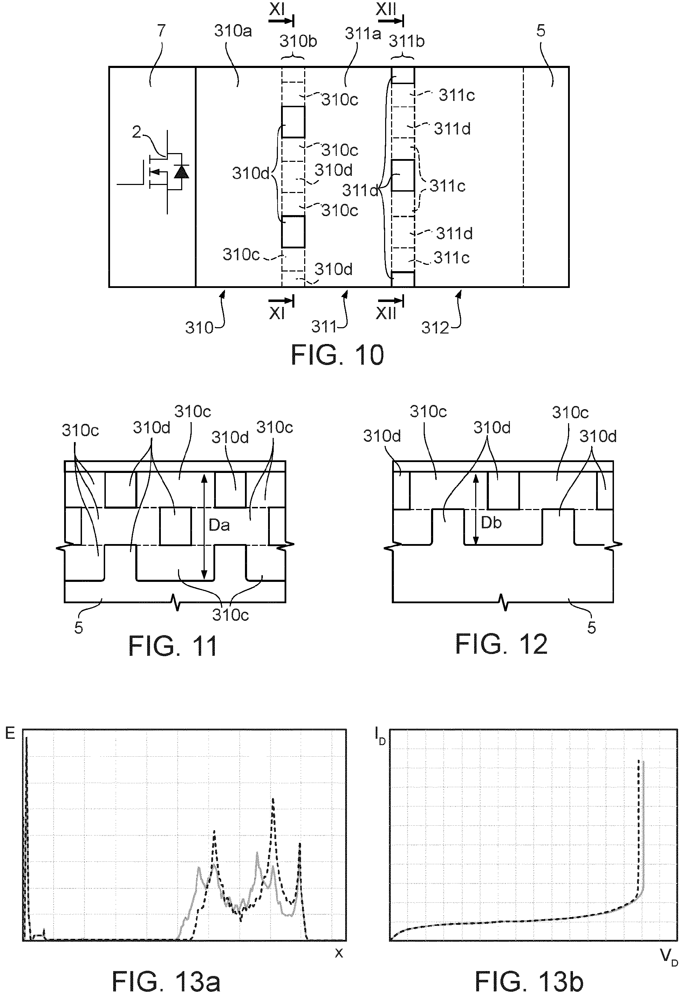

For example, in the embodiment illustrated in Figures 10-12, an edge termination structure 303 formed in the structural layer 5 comprises an inner ring structure 310, an intermediate ring structure 311 and an outer ring structure 312. The inner ring structure 310 and the intermediate ring structure 311 have respective continuous annular regions 310a, 311a and respective transition regions 310b, 311b, with connection regions 310c, 311c alternated with charge control regions 310d, 311d. The charge control regions 310d, 311d are defined by islands or blocks, including respective portions of the structural layer 5 and having the same doping and conductivity type as the structural layer 5. Possibly, the charge control regions 310d, 311d may be connected to the structural layer 5 on one side of the respective ring structures 310, 311 opposite to the front face 5a. At least some of the charge control regions 310d, 311d are located at a distance from the front face 5a of the structural layer 5 in the direction of a z axis perpendicular to the xy plane (and therefore to the front face 5a) and at least some of the charge control regions 310d, 311d have a dimension according to the z axis that is smaller than the depth of the respective ring structure 310, 311. Furthermore, the charge control regions 310d, 311d are distributed in the respective transition regions 310b, 311b and are arranged offset in the direction of the z axis, for example according to a checkerboard pattern (Figures 11 and 12).

In the transition regions, in practice, the charge control regions have the effect of reducing on average the charge density otherwise present in each of the ring structures, at the interface with the adjacent ring structure or, in the case of the outer ring structure, with the structural layer. For example, indicating by Q the local charge density of one of the ring structures, the average charge density Q' in the corresponding transition region is given by: $Q ′ = Q * α$ where α is the ratio between the total volume of the connection regions of the transition region (i.e. the sum of the volumes of all connection regions) and the volume of the transition region. The average charge density accounts for the missing charge in the charge control regions: the larger the volume of the charge control regions, the lower the average charge density in the corresponding transition region. The lower average charge density in the transition regions with respect to the continuous annular regions has the effect of reducing the electric field peaks at the interface between adjacent ring structures. The graph of Figure 13a shows the comparison between the electric field in the edge termination structure 100 of Figure 8 (solid line) and an edge termination structure having ring structures equal in number, shape and dimensions, but with no transition regions (dashed line). The graph of Figure 13b shows the breakdown voltage, which is substantially unchanged in the two cases. The graphs refer to functionally identical devices, with equal epitaxial thicknesses and doping levels and different from each other only for the edge termination structure. As may be seen from the graph of Figure 13a, in the edge termination structure according to the invention, at the interfaces between adjacent ring regions, the electric field has distributed and less intense peaks with respect to the edge termination structure with no transition regions. In practice, the doping profile of the edge termination structure according to the invention better approximates a profile degrading continuously from the inside towards the periphery and is compatible with the definition limits of the lithographic techniques. The reduction of the electric field peaks at the interfaces between adjacent ring structures due to the lower charge density results in less stress for the materials, in particular for the field oxides, and in a lower breakdown probability. The invention therefore allows the reliability of the devices to be safeguarded, preventing premature ageing.

A process for manufacturing an integrated device will be described below, in particular referring to the integrated device 1 illustrated in Figures 1-7. However, it is understood that the same process, with obvious modifications for example in the layout of the masks and of the implant steps, may substantially be used for any embodiment of the integrated device and especially of the edge termination structure.

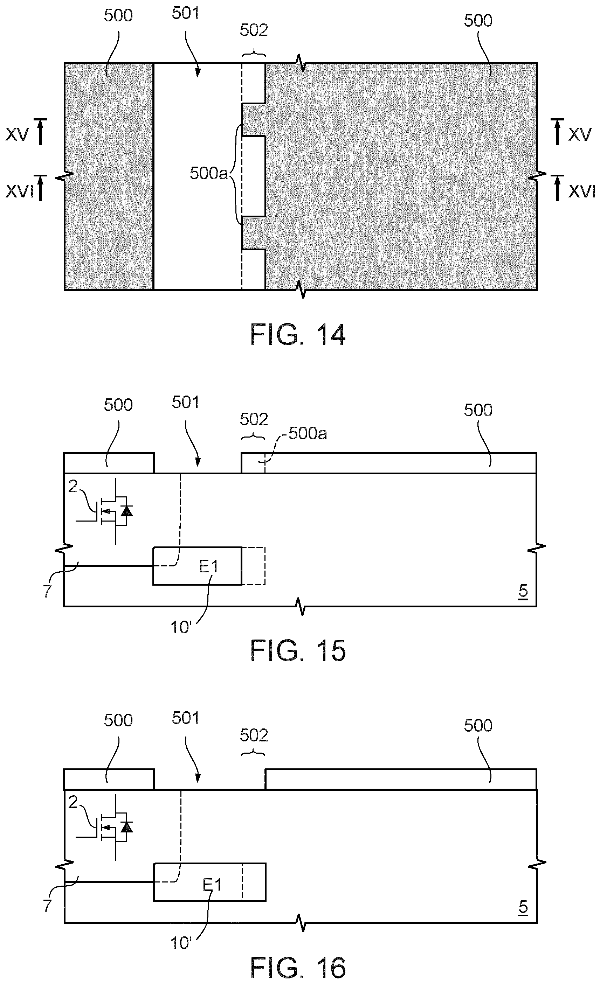

As shown in Figures 14-16, after forming the power device 2 in the functional region 7, a first mask 500 is formed, for example a resist mask obtained by a first photolithographic technique or a silicon oxide or silicon nitride mask. The first mask 500 covers the entire structural layer 5 and leaves exposed a first annular region 501 corresponding to the continuous annular region 10a and to the connection regions 10c of the inner ring structure 10. The first mask 500 comprises blocks 500a in an outer peripheral band 502 of the first annular region 501. In particular, the blocks 500a protect zones intended to form charge control regions 10c of the inner ring structure 10.

A first implant of a second-type (P) doping species is then performed with a concentration such as to obtain the charge density Q and with a first energy E1 such as to reach the maximum depth Da of the inner ring structure 10. In this manner a first implanted well is formed which forms deep portions 10' of the inner ring structure 10. Within the region of the inner ring structure, portions of the structural layer 5 corresponding to the charge control regions 10d are protected from the implant of doping species and maintain the doping type and level of the structural layer 5.

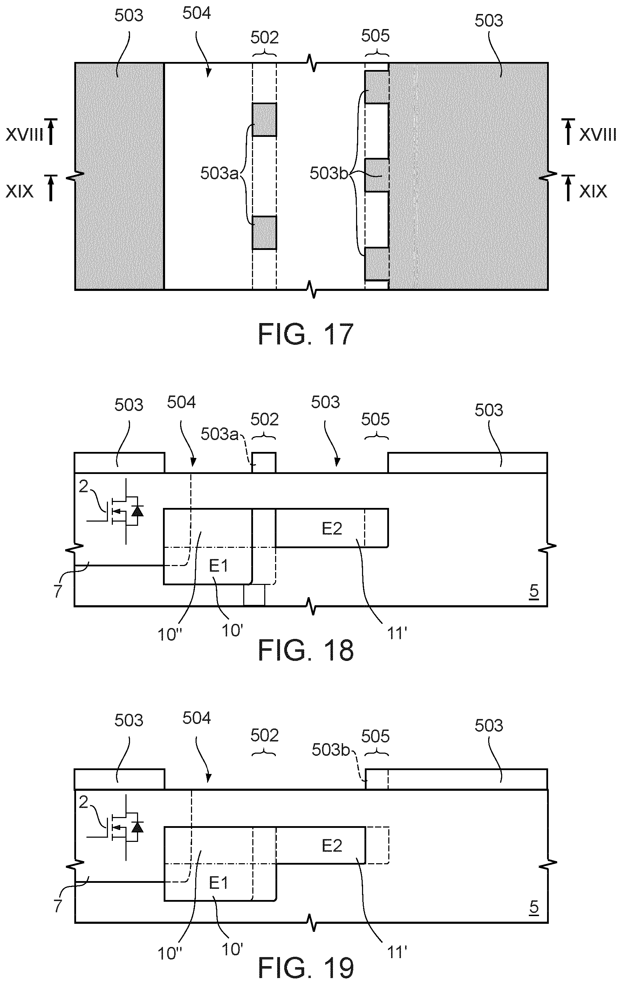

Once the implant has been performed (Figures 17-19), the first mask 500 is removed and in lieu thereof, by a second photolithographic technique, a second mask 503 is formed, for example a resist mask obtained by a second photolithographic technique or a silicon oxide or silicon nitride mask. The second mask 503 covers the functional region 7 and the structural layer 5 and leaves exposed a second annular region 504 corresponding to the continuous annular region 10a and to the connection regions 10c of the inner ring structure 10 and to the continuous annular region 11a and to the connection regions 11c of the intermediate ring structure 11. The second mask 503 comprises blocks 503a in the band 502 of the first annular region 501 and blocks 503b in an outer peripheral band 505 of the second annular region 504. In particular, the blocks 503a protect zones intended to form charge control regions 10c of the inner ring structure 10 and the blocks 503b protect zones intended to form charge control regions 11d of the intermediate ring structure 11. The blocks 503a, while being within the band 502, are not necessarily in the same positions or in any case aligned with respect to the blocks 500a of the first mask 500.

A second implant of the same doping species is performed, with a concentration such as to obtain the charge density Q and with a second energy E2, lower than the first energy E1 and such as to reach the intermediate depth Db of the intermediate ring structure 11. In this manner a second implanted well is formed which, in the region corresponding to the inner ring structure 10, is contiguous to the first implanted well, possibly with a slight overlap to avoid discontinuities in the direction of the z axis. The second implanted well forms portions 10" of the inner ring structure 10 and portions 11' of the intermediate ring structure 11. Portions of the structural layer 5 corresponding to the charge control regions 10d in the region of the inner ring structure 10 and to the charge control regions 11d in the intermediate ring structure 11 are protected from the implant of doping species and maintain the doping type and level of the structural layer 5.

The second mask 503 is then removed and replaced with a third mask 510, for example a resist mask obtained through a third photolithographic technique or a silicon oxide or silicon nitride mask.

The third mask 510 covers the functional region 7 and the structural layer 5 and leaves exposed a third annular region 511 corresponding to the continuous annular region 10a and to the connection regions 10c of the inner ring structure 10, to the continuous annular region 11a and to the connection regions 11c of the intermediate ring structure 11 and to the continuous annular region 12a and to the connection regions 12c of the outer ring structure 12. The third mask 510 comprises blocks 510a in the band 502 of the first annular region 501, blocks 510b in the band 505 of the second annular region 504 and blocks 510c in an outer peripheral band 512 of the second annular region 504. In particular, the blocks 510a protect zones intended to form charge control regions 10d of the inner ring structure 10, the blocks 510b protect zones intended to form charge control regions 11d of the intermediate ring structure 11 and the blocks 510c protect zones intended to form charge control regions 12d of the outer ring structure 12. The blocks 510a, 510b while being within the respective bands 502, 505, are not necessarily in the same positions or in any case aligned with respect to the blocks 500a, 503a, 503b of the first mask 500 and of the second mask 503.

A third implant of the same doping species is performed, with a concentration such as to obtain the charge density Q and with a third energy E3, lower than the first energy E1 and the second energy E2 such as to reach the minimum depth Dc of the outer ring structure 12. In this manner, a third implanted well is formed which, in the region corresponding to the intermediate ring structure 11, is contiguous to the second implanted well, possibly with a slight overlap to avoid discontinuities in the direction of the z axis. The third implanted well forms portions 10‴ of the inner ring structure 10, portions 11" of the intermediate ring structure 11 and the entire outer ring structure 12. Portions of the structural layer 5 corresponding to the charge control regions 10d in the region of the inner ring structure 10, to the charge control regions 11d in the intermediate ring structure 11 are protected from the implant of doping species and maintain the doping type and level of the structural layer 5.

At this point, the edge termination structure 3 is completed and includes the charge control regions 10d, 11d, 12d which, having been preserved from the introduction of the doping species during the implant steps, have the same dopant type and concentration as the structural layer 5.

Finally, terminal processing steps are performed, including forming the field plate oxide 9 on the edge termination structure 3 and forming the metal structure 8. The integrated device 1 of Figures 1-7 is thus obtained.

In general, the number of masks and implant steps is equal to the number of ring structures which form the edge termination structure. Each mask has wider openings than the masks used for deeper implants and comprises respective blocks that protect zones of the structural layer intended to form charge control regions in the implanted wells directly formed through the same mask. The masking and implant steps may be performed in the reverse order with respect to that described, i.e. starting from the outermost and most superficial ring structure up to the innermost and deepest one.

If desired, the dopant concentration may vary along the z axis, instead of being constant. In particular, the implant steps may be performed so that the implanted wells have doping species concentrations different from each other.

Finally, it is clear that modifications and variations may be made to the integrated device and to the method described, without departing from the scope of the present invention, as defined in the attached claims.

## Claims

1. An integrated device (11), comprising:
a semiconductor structural layer (5), including silicon carbide and having a first conductivity type;
a power device (2) integrated in the structural layer (5); and
an edge termination structure (3; 203; 303), extending in a ring around the power device (2) and having a second conductivity type;
wherein the edge termination structure (3; 203; 303) comprises a plurality of ring structures (10, 11, 12; 210, 211, 212; 310, 311, 312) each arranged around the power device (2) and in contiguous pairs;
wherein at least a first one (10, 11; 210, 211; 310, 311) of the ring structures (10, 11, 12; 210, 211, 212; 310, 311, 312) comprises a transition region (10b, 11b; 210b, 211b; 310b, 311b) contiguous to a second one (11, 12; 211, 212; 311, 312) of the ring structures (10, 11, 12; 210, 211, 212; 310, 311, 312);
and wherein the transition region (10b, 11b; 210b, 211b; 310b, 311b) includes connection regions (10c, 11c; 310c, 311c), having the second conductivity type, connected to the second one (11, 12; 211, 212; 311, 312) of the ring structures (10, 11, 12; 210, 211, 212; 310, 311, 312) and alternated with charge control regions (10d, 11d; 310d, 311d) having the first conductivity type;
**characterized in that** the structural layer (5) has a front face (5a) and the ring structures (10, 11, 12; 210, 211, 212; 310, 311, 312) extend from the front face (5a) towards the inside of the structural layer (5) up to respective distinct depths (Da; Db; Dc) decreasing towards the outside of the edge termination structure (3; 203; 303).

2. The device according to claim 1, wherein the ring structures (10, 11, 12; 210, 211, 212; 310, 311, 312) comprise an inner ring structure (10; 210; 310), an outer ring structure (12; 112; 212; 312) and at least one intermediate ring structure (11; 211; 311) between the inner ring structure (10; 210; 310) and the outer ring structure (12; 112; 212; 312).

3. The device according to claim 2, wherein the ring structures (210, 211, 212) comprise a plurality of intermediate ring structures (211) between the inner ring structure (210) and the outer ring structure (212).

4. The device according to claim 2 or 3, wherein the inner ring structure (10; 210; 310) and each intermediate ring structure (11; 211; 311) comprise a respective transition region (10b, 11b; 210b, 211b; 310b, 311b) contiguous to the immediately outer ring structure (10, 11, 12; 210, 211, 212; 310, 311, 312) and wherein the respective transition region (10b, 11b; 210b, 211b; 310b, 311b) includes respective connection regions (10c, 11c; 310c, 311c), having the second conductivity type, connected to the immediately outer ring structure (10, 11, 12; 210, 211, 212; 310, 311, 312) and alternated with charge control regions (10d, 11d; 310d, 311d) having the first conductivity type.

5. The device according to any of claims 2 to 4, wherein the inner ring structure (10; 210; 310) and each intermediate ring structure (11; 211; 311) comprise a respective continuous annular region (10a, 11a; 210a, 211a; 310a, 311a) and the transition regions (10b, 11b; 210b, 211b; 310b, 311b) extend around the respective continuous annular regions (10a, 11a; 210a, 211a; 310a, 311a).

6. The device according to claim 5, wherein the connection regions (10c, 11c; 310c, 311c) join the respective continuous annular regions (10a, 11a; 210a, 211a; 310a, 311a) to the respective immediately outer ring structure (10, 11, 12; 210, 211, 212; 310, 311, 312).

7. The device according to any of claims 2 to 6, wherein the outer ring structure (12; 212) comprises a respective transition region (12b; 212b) externally contiguous to the structural layer (5) and including respective connection regions (12c), having the second conductivity type, contiguous to the structural layer (5) and alternating with charge control regions (12d) having the first conductivity type.

8. The device according to any of claims 2 to 4, wherein the outer ring structure (12; 212) comprises a respective continuous annular region (12c; 210a, 211a) and the respective transition region (12b; 212b) extends around the respective continuous annular region (12c; 210a, 211a).

9. The device according to any of the preceding claims, wherein the charge control regions (10d, 11d; 310d, 311d) are defined by respective portions of the structural layer (5).

10. The device according to any of the preceding claims, wherein the charge control regions (10d, 11d) extend straight from the front face (5a) of the structural layer (5) up to the depth (Da; Db; Dc) of the respective ring structure (10, 11, 12; 210, 211, 212).

11. The device according to any of claims 1 to 9, wherein at least some of the charge control regions (310d, 311d) are located at a distance from the front face (5a) of the structural layer (5) in a direction perpendicular to the front face (5a) and at least some of the charge control regions (310d, 311d) have, in the direction perpendicular to the front face (5a), a dimension smaller than the depth (Da, Db) of the respective ring structure (310, 311).

12. The device according to any of the preceding claims, wherein the power device (2) comprises a peripheral functional region (7), having the second conductivity type, and the edge termination structure (3; 203; 303) is contiguous to the functional region (7).

13. A method for manufacturing an integrated device comprising:
forming a power device (2) in a semiconductor structural layer containing silicon carbide having a first conductivity type;
forming an edge termination structure (3; 203; 303), extending in a ring around the power device (2) and having a second conductivity type;
wherein forming the edge termination structure (3; 203; 303) comprises:
forming a plurality of ring structures (10, 11, 12; 210, 211, 212; 310, 311, 312) each arranged around the power device (2) and in contiguous pairs;
forming, in at least a first one (10, 11; 210, 211; 310, 311) of the ring structures (10, 11, 12; 210, 211, 212; 310, 311, 312), a transition region (10b, 11b; 210b, 211b; 310b, 311b) contiguous to a second one (11, 12; 211, 212; 311, 312) of the ring structures (10, 11, 12; 210, 211, 212; 310, 311, 312); and
forming, in the transition region (10b, 11b; 210b, 211b; 310b, 311b), connection regions (10c, 11c; 310c, 311c), having the second conductivity type, connected to the second one (11, 12; 211, 212; 311, 312) of the ring structures (10, 11, 12; 210, 211, 212; 310, 311, 312) and alternated with charge control regions (10d, 11d; 310d, 311d) having the first conductivity type;
wherein forming the connection regions (10c, 11c; 310c, 311c) alternated with the charge control regions (10d, 11d; 310d, 311d) comprises implanting a doping species into the structural layer (5) and protecting the charge control regions (10d-12d) from the implants;
**characterized in that** implanting comprises sequentially performing a plurality of implants of the doping species at respective distinct depths;
wherein performing each implant of the plurality of implants comprises forming a respective mask (500, 503, 510) and implanting the doping species through the respective mask (500, 503, 510) at the respective depth;
wherein the mask (500, 503, 510) of each implant is configured to expose portions of the structural layer (5) wider with respect to portions of the structural layer (5) exposed by the masks (500, 503, 510) of the deeper implants;
and wherein each mask (500, 503, 510) comprises respective blocks (500a, 503a, 510a) in positions corresponding to respective charge control regions (10d, 11d; 310d, 311d).

## Patentansprüche

1. Integrierte Vorrichtung (11), umfassend:
eine strukturelle Halbleiterschicht (5), die Siliziumkarbid enthält und einen ersten Leitfähigkeitstyp aufweist;
eine in die Strukturschicht (5) integrierte Leistungsvorrichtung (2); und
eine Randabschlussstruktur (3; 203; 303), die sich in einem Ring um die Leistungsvorrichtung (2) herum erstreckt und einen zweiten Leitfähigkeitstyp aufweist;
wobei die Randabschlussstruktur (3; 203; 303) eine Vielzahl von Ringstrukturen (10, 11, 12; 210, 211, 212; 310, 311, 312) umfasst, die jeweils um die Leistungsvorrichtung (2) herum und in zusammenhängenden Paaren angeordnet sind;
wobei mindestens eine erste (10, 11; 210, 211; 310, 311) der Ringstrukturen (10, 11, 12; 210, 211, 212; 310, 311, 312) einen Übergangsbereich (10b, 11b; 210b, 211b; 310b, 311b) mit einer zweiten (11, 12; 211, 212; 311, 312) der Ringstrukturen (10, 11, 12; 210, 211, 212; 310, 311, 312) zusammenhängend umfasst;
und wobei der Übergangsbereich (10b, 11b; 210b, 211b; 310b, 311b) Verbindungsbereiche (10c, 11c; 310c, 311c) enthält, die den zweiten Leitfähigkeitstyp aufweisen, mit dem zweiten (11, 12; 211, 212; 311, 312) der Ringstrukturen (10, 11, 12; 210, 211, 212; 310, 311, 312) verbunden sind und abwechselnd mit Ladekontrollbereichen (10d, 11d; 310d, 311d) sind, die den ersten Leitfähigkeitstyp aufweisen; **dadurch gekennzeichnet, dass** die Strukturschicht (5) eine Vorderseite (5a) aufweist und sich die Ringstrukturen (10, 11, 12; 210, 211, 212; 310, 311, 312) von der Vorderseite (5a) in Richtung der Innenseite der Strukturschicht (5) bis zu jeweiligen unterschiedlichen Tiefen (Da; Db; Dc) erstrecken, die in Richtung der Außenseite der Randabschlussstruktur (3; 203; 303) abnehmen.

2. Vorrichtung nach Anspruch 1, wobei die Ringstrukturen (10, 11, 12; 210, 211, 212; 310, 311, 312) eine innere Ringstruktur (10; 210; 310), eine äußere Ringstruktur (12; 112; 212; 312) und mindestens eine Zwischenringstruktur (11; 211; 311) zwischen der inneren Ringstruktur (10; 210; 310) und der äußeren Ringstruktur (12; 112; 212; 312) umfassen.

3. Vorrichtung nach Anspruch 2, wobei die Ringstrukturen (210, 211, 212) eine Vielzahl von Zwischenringstrukturen (211) zwischen der inneren Ringstruktur (210) und der äußeren Ringstruktur (212) umfassen.

4. Vorrichtung nach Anspruch 2 oder 3, wobei die innere Ringstruktur (10; 210; 310) und jede Zwischenringstruktur (11; 211; 311) einen jeweiligen Übergangsbereich (10b, 11b; 210b, 211b; 310b, 311b) mit der unmittelbar äußeren Ringstruktur (10, 11, 12; 210, 211, 212; 310, 311, 312) zusammenhängend umfassen, und wobei der jeweilige Übergangsbereich (10b, 11b; 210b, 211b; 310b, 311b) jeweilige Verbindungsbereiche (10c, 11c; 310c, 311c) enthält, die den zweiten Leitfähigkeitstyp aufweisen, die mit der unmittelbar äußeren Ringstruktur (10, 11, 12; 210, 211, 212; 310, 311, 312) verbunden sind, und abwechselnd mit Ladekontrollbereichen (10d, 11d; 310d, 311d), die den ersten Leitfähigkeitstyp aufweisen.

5. Vorrichtung nach einem der Ansprüche 2 bis 4, wobei die innere Ringstruktur (10; 210; 310) und jede Zwischenringstruktur (11; 211; 311) einen jeweiligen durchgehenden Ringbereich (10a, 11a; 210a, 211a; 310a, 311a) umfassen, und sich die Übergangsbereiche (10b, 11b; 210b, 211b; 310b, 311b) um die jeweiligen durchgehenden Ringbereiche (10a, 11a; 210a, 211a; 310a, 311a) herum erstrecken.

6. Vorrichtung nach Anspruch 5, wobei die Verbindungsbereiche (10c, 11c; 310c, 311c) die jeweiligen durchgehenden Ringbereiche (10a, 11a; 210a, 211a; 310a, 311a) an die jeweilige unmittelbar äußere Ringstruktur (10, 11, 12; 210, 211, 212; 310, 311, 312) anschließen.

7. Vorrichtung nach einem der Ansprüche 2 bis 6, wobei die Außenringstruktur (12; 212) einen jeweiligen Übergangsbereich (12b; 212b) umfasst, der außen mit der Strukturschicht (5) zusammenhängend ist und jeweilige Verbindungsbereiche (12c) enthält, die den zweiten Leitfähigkeitstyp aufweisen, der mit der Strukturschicht (5) zusammenhängend ist und abwechselnd mit Ladekontrollbereichen (12d) ist, die den ersten Leitfähigkeitstyp aufweisen.

8. Vorrichtung nach einem der Ansprüche 2 bis 4, wobei die Außenringstruktur (12; 212) einen jeweiligen durchgehenden Ringbereich (12c; 210a, 211a) umfasst und sich der jeweilige Übergangsbereich (12b; 212b) um den jeweiligen durchgehenden Ringbereich (12c; 210a, 211a) herum erstreckt.

9. Vorrichtung nach einem der vorstehenden Ansprüche, wobei die Ladekontrollbereiche (10d, 11d; 310d, 311d) durch jeweilige Abschnitte der Strukturschicht (5) definiert sind.

10. Vorrichtung nach einem der vorstehenden Ansprüche, wobei sich die Ladekontrollbereiche (10d, 11d) gerade von der Vorderseite (5a) der Strukturschicht (5) bis zur Tiefe (Da; Db; Dc) der jeweiligen Ringstruktur (10, 11, 12; 210, 211, 212) erstrecken.

11. Vorrichtung nach einem der Ansprüche 1 bis 9, wobei sich mindestens einige der Ladekontrollbereiche (310d, 311d) in einem Abstand zur Vorderseite (5a) der Strukturschicht (5) in einer Richtung senkrecht zur Vorderseite (5a) befinden und mindestens einige der Ladekontrollbereiche (310d, 311d), in der Richtung senkrecht zur Vorderseite (5a) eine Abmessung aufweisen, die kleiner als die Tiefe (Da, Db) der jeweiligen Ringstruktur (310, 311) ist.

12. Vorrichtung nach einem der vorstehenden Ansprüche, wobei die Leistungsvorrichtung (2) einen peripheren Funktionsbereich (7) umfasst, der den zweiten Leitfähigkeitstyp aufweist, und die Randabschlussstruktur (3; 203; 303) mit dem Funktionsbereich (7) zusammenhängend ist.

13. Verfahren zur Herstellung einer integrierten Vorrichtung, umfassend:
Bilden einer Leistungsvorrichtung (2) in einer strukturellen Halbleiterstrukturschicht, die Siliziumkarbid enthält, einen ersten Leitfähigkeitstyp aufweisend;
Bilden einer Randabschlussstruktur (3; 203; 303), die sich in einem Ring um die Leistungsvorrichtung (2) herum erstreckt und einen zweiten Leitfähigkeitstyp aufweist;
wobei Bilden der Randabschlussstruktur (3; 203; 303) umfasst:
Bilden einer Vielzahl von Ringstrukturen (10, 11, 12; 210, 211, 212; 310, 311, 312), die jeweils um die Leistungsvorrichtung (2) herum und in zusammenhängenden Paaren angeordnet sind;
Bilden, in mindestens einer ersten (10, 11; 210, 211; 310, 311) der Ringstrukturen (10, 11, 12; 210, 211, 212; 310, 311, 312), eines Übergangsbereichs (10b, 11b; 210b, 211b; 310b, 311b) mit einer zweiten (11, 12; 211, 212; 311, 312) der Ringstrukturen (10, 11, 12; 210, 211, 212; 310, 311, 312) zusammenhängend; und
Bilden im Übergangsbereich (10b, 11b; 210b, 211b; 310b, 311b) von Verbindungsbereichen (10c, 11c; 310c, 311c), die den zweiten Leitfähigkeitstyp aufweisen, die mit der zweiten (11, 12; 211, 212; 311, 312) der Ringstrukturen (10, 11, 12; 210, 211, 212; 310, 311, 312) verbunden sind, und abwechselnd mit Ladekontrollbereichen (10d, 11d; 310d, 311d), die den ersten Leitfähigkeitstyp aufweisen;
wobei Bilden der Verbindungsbereiche (10c, 11c; 310c, 311c) abwechselnd mit den Ladekontrollbereichen (10d, 11d; 310d, 311d) das Implantieren einer Dotierungsart in die Strukturschicht (5) und Schützen der Ladekontrollbereiche (10d-12d) vor den Implantaten umfasst;
**dadurch gekennzeichnet, dass** Implantieren sequenzielles Durchführen einer Vielzahl von Implantaten der Dotierungsart in jeweiligen unterschiedlichen Tiefen umfasst;
wobei Durchführen jedes Implantats der Vielzahl von Implantaten Bilden einer jeweiligen Maske (500, 503, 510) und Implantieren der Dotierungsart durch die jeweilige Maske (500, 503, 510) in der jeweiligen Tiefe umfasst; wobei die Maske (500, 503, 510) jedes Implantats konfiguriert ist, um Abschnitte der Strukturschicht (5) breiter in Bezug auf Abschnitte der Strukturschicht (5) freizulegen, die durch die Masken (500, 503, 510) der tieferen Implantate freigelegt sind;
und wobei jede Maske (500, 503, 510) jeweilige Blöcke (500a, 503a, 510a) in Positionen umfasst, die jeweiligen Ladekontrollbereichen (10d, 11d; 310d, 311d) entsprechen.

## Revendications

1. Dispositif intégré (11) comprenant :
une couche structurelle de semiconducteur (5), comprenant du carbure de silicium et ayant un premier type de conductivité ;
un dispositif de puissance (2) intégré à la couche structurelle (5) ; et
une structure de terminaison de bord (3 ; 203 ; 303) s'étendant en anneau autour du dispositif de puissance (2) et ayant un deuxième type de conductivité ;
dans lequel la structure de terminaison de bord (3 ; 203 ; 303) comprend une pluralité de structures en anneau (10, 11, 12 ; 210, 211, 212 ; 310, 311, 312) toutes disposées autour du dispositif de puissance (2) et par paires contiguës ;
dans lequel au moins une première (10, 11 ; 210, 211 ; 310, 311) des structures en anneau (10, 11, 12 ; 210, 211, 212 ; 310, 311, 312) comprend une région de transition (10b, 11b ; 210b, 211b ; 310b, 311b) contiguë à une deuxième (11, 12 ; 211, 212 ; 311, 312) des structures en anneau (10, 11, 12 ; 210, 211, 212 ; 310, 311, 312) ;
et dans lequel la région de transition (10b, 11b ; 210b, 211b ; 310b, 311b) comporte des régions de connexion (10c, 11c ; 310c, 311c), ayant le deuxième type de conductivité, connectées à la deuxième (11, 12 ; 211, 212 ; 311, 312) des structures en anneau (10, 11, 12 ; 210, 211, 212 ; 310, 311, 312) et alternant avec des régions de contrôle de charge (10d, 11d ; 310d, 311d) ayant le premier type de conductivité ;
**caractérisé en ce que** la couche structurelle (5) a une face avant (5a) et les structures en anneau (10, 11, 12 ; 210, 211, 212 ; 310, 311, 312) s'étendent de la face avant (5a) vers l'intérieur de la couche structurelle (5) jusqu'à des profondeurs distinctes respectives (Da ; Db ; Dc) diminuant vers l'extérieur de la structure de terminaison de bord (3 ; 203 ; 303).

2. Dispositif selon la revendication 1, dans lequel les structures en anneau (10, 11, 12 ; 210, 211, 212 ; 310, 311, 312) comprennent une structure en anneau intérieure (10 ; 210 ; 310), une structure en anneau extérieure (12 ; 112 ; 212 ; 312) et au moins une structure en anneau intermédiaire (11 ; 211 ; 311) entre la structure en anneau intérieure (10 ; 210 ; 310) et la structure en anneau extérieure (12 ; 112 ; 212 ; 312).

3. Dispositif selon la revendication 2, dans lequel les structures en anneau (210, 211, 212) comprennent une pluralité de structures en anneau intermédiaires (211) entre la structure en anneau intérieure (210) et la structure en anneau extérieure (212).

4. Dispositif selon la revendication 2 ou 3, dans lequel la structure en anneau intérieure (10 ; 210 ; 310) et chaque structure en anneau intermédiaire (11 ; 211 ; 311) comprennent une région de transition respective (10b, 11b ; 210b, 211b ; 310b, 311b) contiguë à la structure en anneau immédiatement extérieure (10, 11, 12 ; 210, 211, 212 ; 310, 311, 312) et dans lequel la région de transition respective (10b, 11b ; 210b, 211b ; 310b, 311b) comporte des régions de connexion respectives (10c, 11c ; 310c, 311c), ayant le deuxième type de conductivité, connectées à la structure en anneau immédiatement extérieure (10, 11, 12 ; 210, 211, 212 ; 310, 311, 312) et alternant avec des régions de contrôle de charge (10d, 11d ; 310d, 311d) ayant le premier type de conductivité.

5. Dispositif selon l'une quelconque des revendications 2 à 4, dans lequel la structure en anneau intérieure (10 ; 210 ; 310) et chaque structure en anneau intermédiaire (11 ; 211 ; 311) comprennent une région annulaire continue respective (10a, 11a ; 210a, 211a ; 310a, 311a) et les régions de transition (10b, 11b ; 210b, 211b ; 310b, 311b) s'étendent autour des régions annulaires continues respectives (10a, 11a ; 210a, 211a ; 310a, 311a).

6. Dispositif selon la revendication 5, dans lequel les régions de connexion (10c, 11c ; 310c, 311c) relient les régions annulaires continues respectives (10a, 11a ; 210a, 211a ; 310a, 311a) à la structure en anneau immédiatement extérieure respective (10, 11, 12 ; 210, 211, 212 ; 310, 311, 312).

7. Dispositif selon l'une quelconque des revendications 2 à 6, dans lequel la structure en anneau extérieure (12 ; 112) comprend une région de transition respective (12b ; 212b) extérieurement contiguë à la couche structurelle (5) et comportant des régions de connexion respectives (12c), ayant le deuxième type de conductivité, contiguës à la couche structurelle (5) et alternant avec des régions de contrôle de charge (12d) ayant le premier type de conductivité.

8. Dispositif selon l'une quelconque des revendications 2 à 4, dans lequel la structure en anneau extérieure (12 ; 112) comprend une région annulaire continue respective (12c ; 210a, 211a) et la région de transition respective (12b ; 212b) s'étend autour de la région annulaire continue respective (12c ; 210a, 211a).

9. Dispositif selon l'une quelconque des revendications précédentes, dans lequel les régions de contrôle de charge (10d, 11d ; 310d, 311d) sont définies par des parties respectives de la couche structurelle (5).

10. Dispositif selon l'une quelconque des revendications précédentes, dans lequel les régions de contrôle de charge (10d, 11d) s'étendent tout droit depuis la face avant (5a) de la couche structurelle (5) jusqu'à la profondeur (Da ; Db ; Dc) de la structure en anneau respective (10, 11, 12 ; 210, 211, 212).

11. Dispositif selon l'une quelconque des revendications 1 à 9, dans lequel au moins une partie des régions de contrôle de charge (310d, 311d) se trouvent à distance de la face avant (5a) de la couche structurelle (5) dans une direction perpendiculaire à la face avant (5a) et au moins une partie des régions de contrôle de charge (310d, 311d) ont, dans la direction perpendiculaire à la face avant (5a), une dimension plus petite que la profondeur (Da, Db) de la structure en anneau respective (310, 311).

12. Dispositif selon l'une quelconque des revendications précédentes, dans lequel le dispositif de puissance (2) comprend une région fonctionnelle périphérique (7), ayant le deuxième type de conductivité, et la structure de terminaison de bord (3 ; 203 ; 303) est contiguë à la région fonctionnelle (7).

13. Procédé de fabrication d'un dispositif intégré comprenant les étapes suivantes :
former un dispositif de puissance (2) dans une couche structurelle de semiconducteur contenant du carbure de silicium ayant un premier type de conductivité ;
former une structure de terminaison de bord (3 ; 203 ; 303) s'étendant en anneau autour du dispositif de puissance (2) et ayant un deuxième type de conductivité ;
dans lequel la formation de la structure de terminaison de bord (3 ; 203 ; 303) comprend les opérations suivantes :
former une pluralité de structures en anneau (10, 11, 12 ; 210, 211, 212 ; 310, 311, 312) toutes disposées autour du dispositif de puissance (2) et par paires contiguës ;
former, dans au moins une première (10, 11 ; 210, 211 ; 310, 311) des structures en anneau (10, 11, 12 ; 210, 211, 212 ; 310, 311, 312), une région de transition (10b, 11b ; 210b, 211b ; 310b, 311b) contiguë à une deuxième (11, 12 ; 211, 212 ; 311, 312) des structures en anneau (10, 11, 12 ; 210, 211, 212 ; 310, 311, 312) ; et
former, dans la région de transition (10b, 11b ; 210b, 211b ; 310b, 311b), des régions de connexion (10c, 11c ; 310c, 311c), ayant le deuxième type de conductivité, connectées à la deuxième (11, 12 ; 211, 212 ; 311, 312) des structures en anneau (10, 11, 12 ; 210, 211, 212 ; 310, 311, 312) et alternant avec des régions de contrôle de charge (10d, 11d ; 310d, 311d) ayant le premier type de conductivité ;
dans lequel la formation des régions de connexion (10c, 11c ; 310c, 311c) en alternance avec les régions de contrôle de charge (10d, 11d ; 310d, 311d) comprend le fait d'implanter une espèce dopante dans la couche structurelle (5) et de protéger les régions de contrôle de charge (10d-12d) des implants ;
**caractérisé en ce que** l'implantation comprend le fait de réaliser de façon séquentielle une pluralité d'implants de l'espèce dopante à des profondeurs distinctes respectives ;
dans lequel la réalisation de chaque implant de la pluralité d'implants comprend le fait de former un masque respectif (500, 503, 510) et d'implanter l'espèce dopante à travers le masque respectif (500, 503, 510) à la profondeur respective ;
dans lequel le masque (500, 503, 510) de chaque implant est configuré pour exposer des parties de la couche structurelle (5) plus larges que des parties de la couche structurelle (5) exposées par les masques (500, 503, 510) des implants les plus profonds ;
et dans lequel chaque masque (500, 503, 510) comprend des blocs respectifs (500a, 503a, 510a) dans des positions correspondant à des régions de contrôle de charge respectives (10d, 11d ; 310d, 311d).
